## Europäisches Patentamt

## European Patent Office

## Office européen des brevets

(19)

(11) Veröffentlichungsnummer: **0 174 473**
**B1**

(12) **EUROPÄISCHE PATENTSCHRIFT**

(45) Veröffentlichungstag der Patentschrift:
07.02.90

(21) Anmeldenummer: **85109212.2**

(22) Anmeldetag: **23.07.85**

(51) Int. Cl.⁵: **H 01 L 27/06, F 02 P 3/04**

(54) Monolitisch integrierte Leistungsendstufe.

(30) Priorität: **29.08.84 DE 3431676**

(43) Veröffentlichungstag der Anmeldung:
**19.03.86 Patentblatt 86/12**

(45) Bekanntmachung des Hinweises auf die Patenterteilung:
**07.02.90 Patentblatt 90/06**

(84) Benannte Vertragsstaaten:
**DE FR GB**

(86) Entgegenhaltungen:
WO-A-83/02528
WO-A-85/05223
DE-A-2 452 023
DE-A-2 842 923
DE-A-2 911 536
DE-A-3 122 249
US-A-4 034 395

RADIO FERNSEHEN ELEKTRONIK, Band 28, Nr. 7, Juli 1979, Seiten 447-449, Berlin, DE; C. KUHNEL: "Bipolare und MOS-Bauelemente auf einem Chip"

PATENTS ABSTRACTS OF JAPAN, Band 6, Nr. 132 (E-119) 1010 , 17. Juli 1982; & JP - A - 57 59371 (HITACHI SEISAKUSHO K.K.) 09.04.1982

(73) Patentinhaber: **ROBERT BOSCH GMBH**
**Postfach 50**
**D-7000 Stuttgart 1 (DE)**

(72) Erfinder: **Bodig, Bernd**
**Bussardweg 7**
**D-7022 Leinfelden-Echterdingen (DE)**
Erfinder: **Gademann, Lothar, Dipl.-Ing.**
**Sülchenstrasse 42**
**D-7407 Rottenburg (DE)**
Erfinder: **Höhne, Gerd, Dipl.-Ing.**
**Hölderlinstrasse 6**
**D-7140 Ludwigsburg (DE)**
Erfinder: **Michel, Hartmut, Dipl.-Ing.**
**Herderstrasse 74**
**D-7410 Reutlingen (DE)**

**Beschreibung**

**Stand der Technik**

Die Erfindung betrifft eine monolithisch integrierte Leistungsendstufe nach dem Oberbegriff des Patentanspruchs 1.

Als derartige Leistungsendstufen sind bereits Darlingtontransistorschaltungen bekannt, die zur Ansteuerung von Zündspulen in Kraftfahrzeugen verwendet werden können.

Aus der WO-A-8 302 528 ist eine als monolithisch integrierte Halbleiteranordnung ausgebildete Darlingtontransistorschaltung bekannt. Die Transistoren dieser bekannten Transistorschaltung sind einem gemeinsamen Substrat in Planartechnik monolithisch integriert. Das Substrat bildet dabei die Kollektorzonen der beiden Transistoren. Diese Halbleiteranordnung umfaßt außer den beiden Transistoren einen Spannungsteiler, mit dem das Potential einer Deckelektrode festgelegt wird. Mit Hilfe dieses Spannungsteilers und der Deckelektrode lassen sich zwar die Durchbruchsspannungen der Basis-Kollektor-Übergänge der beiden Transistoren der Darlingtonschaltung auf bestimmte Werte einstellen. Mittel zur Strombegrenzung sind aber bei dieser bekannten Halbleiteranordnung nicht vorgesehen.

**Vorteile der Erfindung**

Die erfindungsgemäße Leistungsendstufe mit den Merkmalen des Patentanspruchs 1 hat demgegenüber den Vorteil, daß mit Hilfe des Strombegrenzungstransistors und des ersten Spannungsteilers eine Strombegrenzung erreicht wird. Die Temperaturkoeffizienten dieser Schaltungselemente können dabei so aufeinander abgestimmt werden, daß entweder eine temperaturkompensierte Strombegrenzung oder eine Strombegrenzung mit vorgegebenem Temperaturgang erreicht wird. Weitere Vorteile ergeben sich aus den Patentansprüchen 2 bis 11 und aus der Beschreibung.

**Zeichnung**

Ausführungsbeispiele der erfindungsgemäßen Leistungsendstufe sind in der Zeichnung dargestellt und in der nachfolgenden Beschreibung näher erläutert. Es zeigen:

Figur 1 einen Schnitt durch eine monolithisch integrierte Leistungsendstufe mit wenigstens einer zusätzlich eindiffundierten Wanne für die Aufnahme peripherer Schaltungselemente,

Figur 2 den Schnitt im Bereich eines peripheren bipolaren Lateraltransistors,

Figur 3 den Schnitt im Bereich eines peripheren Lateral-MOS-Transistors (n-Kanal),

Figur 4 den Schnitt im Bereich eines peripheren Lateral-MOS-Transistors (p-Kanal),

Figur 5 den Schnitt im Bereich eines peripheren Widerstandes für Spannungen, die größer als die Kollektorspannung der Leistungsendstufe sind,

Figur 6 den Schnitt im Bereich eines peripheren Widerstandes für Spannungen, die kleiner als die Kollektorspannung der Leistungsendstufe sind,

Figur 7 den Schnitt einer peripheren MOS-Kapazität und

Figur 8 die Schaltungsanordnung einer Leistungsendstufe mit Temperaturstabilisierter Strombegrenzung und weiteren peripheren Schaltungselementen.

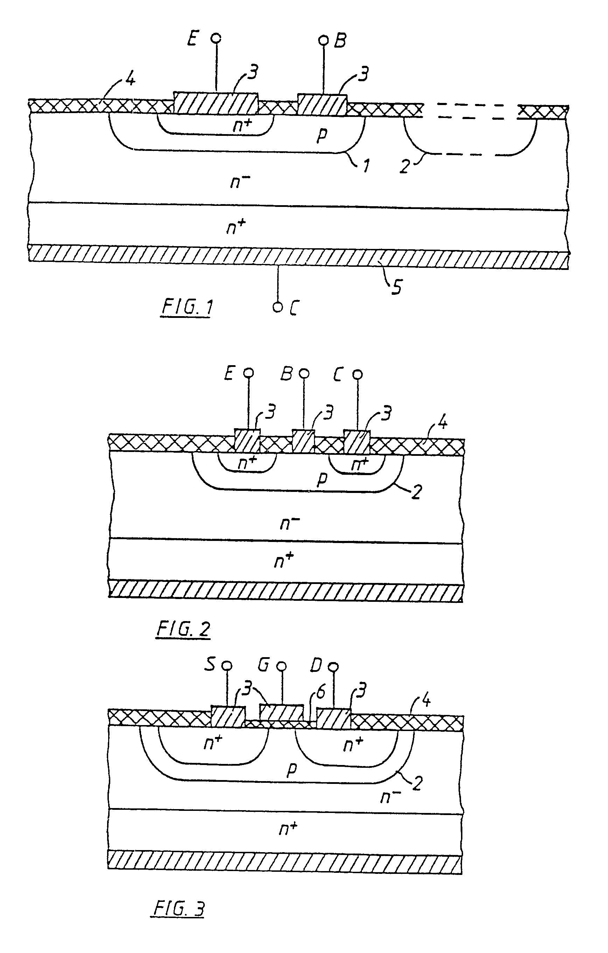

Figur 1 zeigt einen Ausschnitt einer monolithisch integrierten Halbleiteranordnung. Das Halbleiterplättchen besteht aus n⁻-leitendem Silizium, in das zwei p-Wannen 1, 2 eindiffundiert sind. Die p-Wanne 1 ist Teil der Leistungsendstufe, während die p-Wanne 2 für periphere Schaltungselemente vorgesehen ist. In Figur 1 sind Metallisierungen 3 für den Emitter- und den Basisanschluß eines Leistungstransistors ersichtlich. Die übrige Oberfläche der dargestellten Halbleiteranordnung ist mit einer aus Siliziumdioxid bestehenden Isolationsschicht 4 überdeckt, während an der Unterseite eine Metallisierung 5 für den Anschluß des Kollektors C vorgesehen ist.

Bei dem in Figur 2 dargestellten Beispiel für eine periphere Anordnung handelt es sich um einen bipolaren Lateraltransistor. Zu diesem Zweck sind für den Emitter E und den Kollektor C n⁺-Gebiete in die p-Wanne 2 eindiffundiert. Eine zwischen diesen beiden Gebieten befindliche Metallisierung dient als Anschluß für die Basis B.

Die in Figur 3 dargestellte periphere Anordnung stellt einen lateralen MOS-Transistor dar, der als n-Kanal-Transistor ausgeführt ist. Der Aufbau dieses Transistors unterscheidet sich im wesentlichen durch die Anordnung der Steuerelektrode, deren Metallisierung über einer dünnen Oxidschicht 6 aufgebracht ist. Die Anschlüsse S, G, D stellen die Source-, Gate- und Drain-Anschlüsse dar.

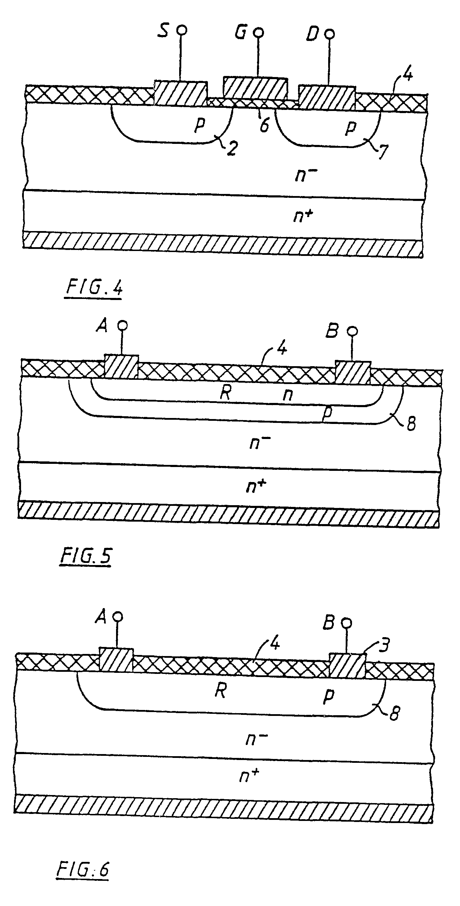

Figur 4 zeigt den Schnitt eines entsprechenden lateralen MOS-Transistors, der jedoch als p-Kanal-Transistor ausgebildet ist. Hierzu sind zwei p-Wannen 2, 7 vorgesehen. Zur Realisierung eines ohm'schen Widerstandes R, ist gemäß Figur 5 in eine p-Wanne 8 eine n-Zone eindiffundiert, die den Widerstand R darstellt, der zwischen zwei Anschlüssen A und B liegt. Dieser Widerstand R ist für Spannungen geeignet, die größer sind als die Kollektorspannung der zugehörigen Leistungsendstufe. Für Spannungen, die kleiner als die Kollektorspannung der Leistungsendstufe sind, wird der Widerstand R gemäß Figur 6 ausgebildet. Dort bildet direkt die p-Wanne 8 den Widerstand R.

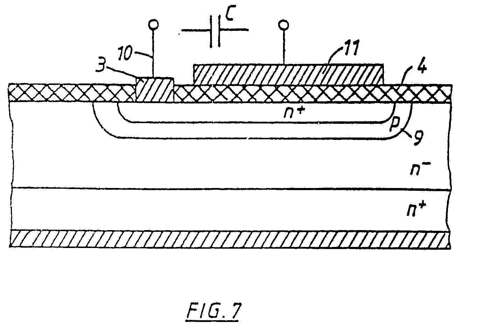

Figur 7 zeigt die Realisierung einer MOS-Kapazität, die im Bereich einer p-Wanne 9 angeordnet ist. Zu diesem Zweck ist eine n⁺-Zone in die p-Wanne 9 eindiffundiert und mit einem ersten Anschluß 10 verbunden. Der zweite Anschluß Anschluß 10 verbunden. Der zweite Anschluß des Kondensators ist mit einer Metallisierungsschicht 11 verbunden, die über der genannten $n^+$-Zone im Abstand angeordnet ist. Der Abstand wird durch eine dazwischenliegende Isolationsschicht 4 bestimmt.

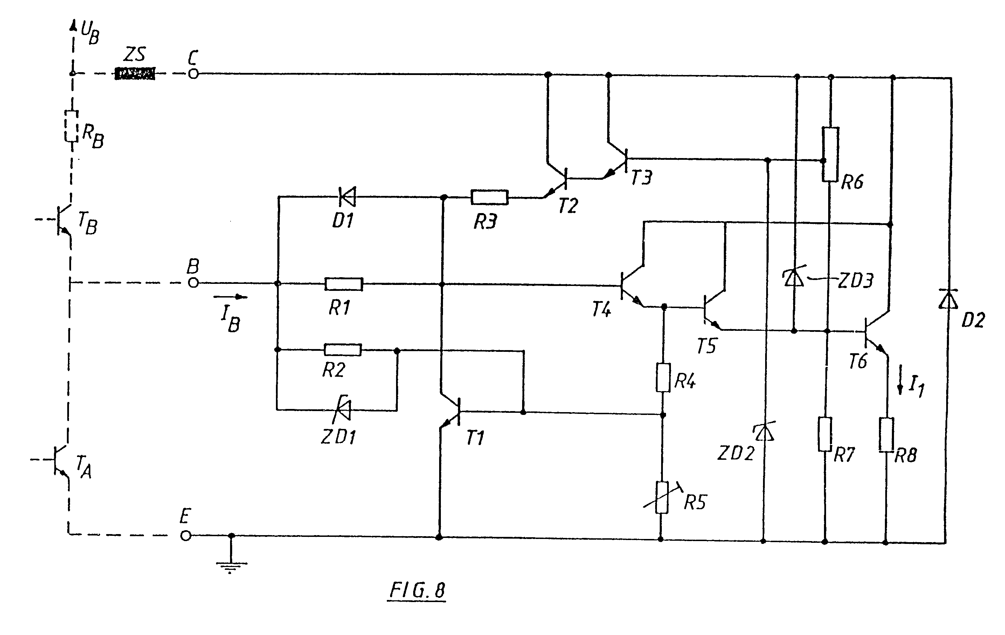

Die in Figur 8 dargestellte Schaltungsanordnung umfaßt eine Vielzahl von peripheren Schaltungselementen, die zusammen mit einer Leistungsendstufe auf einer gemeinsamen Halbleitergrundschicht integriert sind. Die Leistungsendstufe kann beispielsweise für einen Ausgangsstrom von etwa 5 Ampere und eine Ausgangsspannung von etwa 200 Volt ausgelegt sein. Es sind aber auch durchaus höhere Ströme und höhere Spannungen realisierbar.

Es sind drei Transistoren T1, T2, T3 als periphere Transistoren vorgesehen, wobei der als Strombegrenzer dienende Transistor T1 als npn-Lateraltransistor ausgebildet ist, dessen Emitter- und Kollektorstruktur im gleichen Arbeitsgang mit dem Emitter des Leistungstransistors T6 in eine p-Wanne eingebracht ist.

Der Kollektor des Transistors T1 ist mit der Basis eines Treibertransistors T4 und mit einem Basisvorwiderstand R1 verbunden. Dem Basisvorwiderstand R1 ist eine Diode D1 parallel geschaltet, deren Anode mit der Basis des als npn-Transistors ausgebildeten Treibertransistors T4 verbunden ist. Die Eingangsklemme B der Zündungsendstufe ist über den Basisvorwiderstand R1 mit der Basis des Treibertransistors T4 verbunden. Der Treibertransistor T4 bildet mit den beiden ihm nachgeschalteten Transistoren T5 und T6 eine als Darlington-Schaltung ausgebildete Leistungsendstufe.

Zur Temperaturstabilisierung der Strombegrenzung ist zwischen dem Emitter des Treibertransistors T4 und der Eingangsklemme E eine aus zwei Widerständen R4, R5 bestehender Spannungsteiler geschaltet, wobei der Widerstand R5 als abgleichbarer Widerstand ausgebildet ist. Zur Stromregelung ist außerdem ein weiterer Widerstand R8 vorgesehen.

Die der Stromregelung dienenden Widerstände R4, R5, R8 sind als integrierte, durch Ionenimplantation erzeugte Widerstände ausgebildet und vorzugsweise unterschiedlich hoch dotiert, so daß sich unterschiedliche Temperaturkoeffizienten bezüglich ihrer Widerstandswerte ergeben. Beim Vormessen ist ein Abgleich des Widerstandes R5 möglich. Er wird in der Halbleiterstruktur so ausgebildet, daß durch von außen zuführbare Leistung Verbindungen verändert werden können, wie dies beispielsweise in der DE-OS-3 201 545 bereits beschrieben ist.

Die unterschiedliche Dotierung der Widerstände R4 und R5 erhält die am Abgriff des Spannungsteilers auftretende Spannung einen gewünschten Temperaturgang. Auf diese Weise kann der über den Transistor T1 abfließende Strom so geregelt werden, daß der in die Basis des Treibertransistors T4 fließende Basisstrom und damit auch der durch eine angeschlossene Zündspule ZS fließende Strom $I_1$, im gewünschten Maße begrenzt bzw. geregelt wird.

Zwischen der Anschlußklemme B und der Basis des als Strombegrenzers dienenden Transistors T1 ist eine erste Zenerdiode ZD1 vorgesehen, die im Überspannungsfall ein Abschalten der Endstufe bewirkt. Die Zenerspannung kann dabei so gewählt sein, daß bei einer Batteriespannung $U_B$ größer cirka 20V der Transistor T1 leitend wird und die Leistungsendstufe damit sperrt. Der Zenerdiode ZD1 ist ein Widerstand R2 parallel geschaltet, der als Batteriespannungs-Gegenkopplung für die Stromregelung dient. Dieser Widerstand R2 und auch der Widerstand R1 sind als n-Material realisiert, welches in eine p-Wanne eingebracht wird. Der Widerstand R1 kann im Basis-p-Material zusammen mit der Emitter-Diffusion als dünner n-Streifen eingebracht werden.

Weiterhin sind periphere Schaltungselemente für eine funkenfreie Ruhestrom-Abschaltung der Zündungsendstufe vorgesehen. Hierzu sind die Transistoren T2, T3, eine weitere Zenerdiode ZD2 und die beiden Widerstände R3 und R6 vorgesehen.

Im Normalbetrieb soll im Zündzeitpunkt gleichzeitig der Transistor $T_B$ sperren und der Transistor $T_A$ leitend werden, die als externe Transistoren vorgesehen sind und über einen Widerstand $R_B$ mit der Batteriespannung und der Zündspule in Verbindung stehen. Im Falle einer Ruhestrom-Abschaltung sollen $T_B$ und gleichzeitig $T_A$ sperren.

Da bei der Ruhestrom-Abschaltung der Transistor $T_A$ gesperrt ist, kann der über die Transistoren T3, T2 und den Widerstand R3 fließende Steuerstrom nicht über die Diode D1 an Masse abfließen, so daß der Treibertransistor T4 und damit die Leistungsendstufe bei einer durch den Teiler R6 limitierten Primärspannung von zum Beispiel 35V aufgesteuert wird. Die Sekundärspannung der Zündspule ZS bleibt somit auf einem niedrigen, nicht zu einem Zündfunken führenden Wert. Die Zenerdiode ZD2 begrenzt den Strom über die Transistoren T3, T2 und den Widerstand R3 bei leitendem Transistor $T_A$ und bei Spannungen »35V.

Eine weitere Zenerdiode ZD3 dient der Spannungsbegrenzung bei Normalbetrieb. Beispielsweise kann eine Klammerspannung von 350V durch dieses Bauelement festgelegt sein. Außerdem kann am Ausgang der Darlington-Schaltung eine Inversdiode D2 vorgesehen sein.

Ist die Zündungsendstufe aufgesteuert, d.h. durch die Zündspule ZS fließt ein Strom $I_1$, ist der Transistor $T_B$ geöffnet und der Transistor $T_A$ gesperrt. Zur Erzeugung des Zündfunkens wird dann der Transistor TB gesperrt und der Transistor $T_A$ leitend, wobei über die Diode D1 von der Basis des Transistors T4 Strom zur Masse abfließen kann, wodurch ein schnelleres Abschalten der Endstufe erreicht wird. Ohne die Diode D1 würde der Widerstand R1, der beispielsweise einen Widerstandswert von 100 Ω haben kann, einem schnellen Abschalten entgegenwirken.

Der Leistungstransistor T6 ist mit dem an Masse liegenden Widerstand R8 verbunden, der auch als Stromfühler-Widerstand bezeichnet werden kann. Der Leistungstransistor T6 und der Widerstand R8 können in vorteilhafter Weise als Parallelschaltung von mehreren Einzeltransistoren, die über eine entsprechende Anzahl von Emittervorwiderständen gegeneinander stabilisiert sind, realisiert sein.

Durch monolithische Integration sind die genannten Merkmale und Funktionselemente in einem einzigen Bauelement realisierbar. Dadurch erhält man eine minimierung der Baugröße, hohe Zuverlässigkeit durch Wegfall zusätzlicher Bauelemente und es ist eine kostengünstige Fertigung möglich. Die Halbleiterschaltung kann beispielsweise in einem Gehäuse, wie es für Leistungstransistoren üblich ist, angeordnet werden. Eine äußere Beschaltung zur Strombegrenzung ist nicht mehr erforderlich.

**Patentansprüche**

1. Monolithisch integrierte Leistungsendstufe zum Schalten einer induktiven Last (ZS) mit einer Darlingtontransistor-Kombination, die einen Treibertransistor (T4) und einen Leistungstransistor (T6) einschließt, wobei die Basis des Treibertransistors (T4) mit einer Eingangsklemme (B) verbunden ist und wobei ferner die Emitter-Kollektor-Strecke des Leistungstransistors (T6) zu der induktiven Last (ZS) in Reihe geschaltet ist, dadurch gekennzeichnet, daß ein Strombegrenzungstransistor (T1) und ein erster Spannungsteiler (R4, R5) vorgesehen sind, daß der erste Spannungsteiler aus einem ersten (R4) und einem zweiten ohmschen Widerstand (R5) mit verschiedenen Temperaturkoeffizienten besteht, mit seinen Enden zwischen einem Punkt mit festem Potential (E) und dem Emitter des Treibertransistors (T4) angeschlossen ist und mit seinem Abgriff an der Basis des Strombegrenzungstransistors (T1) liegt und daß der Strombegrenzungstransistor (T1) mit seinem Kollektor an die Basis des Treibertransistors (T4) und mit seinem Emitter an den Punkt mit festem Potential (E) angeschlossen ist.

2. Leistungsendstufe nach Anspruch 1 dadurch gekennzeichnet, daß zwischen den Punkt mit festem Potential (E) und die Emitter-Kollektor-Strecke des Leistungstransistors (T6) ein zusätzlicher, als Stromregelwiderstand dienender ohmscher Widerstand (R8) geschaltet ist, dessen Temperaturkoeffizient von den Temperaturkoeffizienten des ersten (R4) und des zweiten ohmschen Widerstandes (R5) verschieden ist.

3. Leistungsendstufe nach Anspruch 2, dadurch gekennzeichnet, daß die ohmschen Widerstände (R4, R5, R8), deren Widerstandswerte verschiedene Temperaturkoeffizienten haben, vom Ionenimplantationstyp sind.

4. Leistungsendstufe nach einem der Ansprüche 1 bis 3, dadurch gekennzeichnet, daß derjenige Widerstand (R5) des ersten Spannungsteilers (R4, R5), der an den Punkt mit festem Potential (E) angeschlossen ist, trimmbar ist, um die Leistungsendstufe an ihren jeweiligen Verwendungszweck anzupassen.

5. Leistungsendstufe nach einem der Ansprüche 1 bis 4, dadurch gekennzeichnet, daß zwischen der Basis des Treibertransistors (T4) und der Eingangsklemme (B) der Leistungsendstufe ein Eingangsserienwiderstand (R1) geschaltet ist.

6. Leistungsendstufe nach Anspruch 5, dadurch gekennzeichnet, daß der Treibertransistor (T4) ein npn-Transistor ist und daß eine Diode (D1) zu dem Eingangsserienwiderstand (R1) parallelgeschaltet ist, wobei die Anode der Diode (D1) an die Basis des Treibertransistors (T4) angeschlossen ist.

7. Leistungsendstufe nach Anspruch 5 oder 6, dadurch gekennzeichnet, daß eine erste Zenerdiode (ZD1) zwischen die Eingangsklemme (B) und die Basis des Strombegrenzungstransistors (T1) geschaltet ist und daß ein Widerstand (R2) zu der ersten Zenerdiode (ZD1) parallelgeschaltet ist, so daß die Leistungsendstufe im wesentlichen dann abgeschaltet wird, wenn die Spannung an der Eingangsklemme (B) die Zenerspannung der ersten Zenerdiode (ZD1) merklich übersteigt.

8. Monolithisch integrierte Leistungsendstufe zum Schalten einer insbesondere als Zündspule dienenden induktiven Last (ZS) nach einem der Ansprüche 1 bis 7, dadurch gekennzeichnet, daß der Basis-Kollektor-Strecke des Leistungstransistors (T6) ein zweiter Spannungsteiler (R6) parallelgeschaltet ist, daß an einen Abgriff des zweiten Spannungsteilers (R6) die Basis eines Steuertransistors (T2, T3) angeschlossen ist, dessen Kollektor an den Kollektor des Leistungstransistors (T6) angeschlossen ist und dessen Emitter mit der Basis des Treibertransistors (T4) verbunden ist, und daß zwischen einen Abgriff des zweiten Spannungsteilers (R6) und den Emitter des Leistungstransistors (T6) eine zweite Zenerdiode (ZD2) geschaltet ist.

9. Leistungsendstufe nach Anspruche 8, dadurch gekennzeichnet, daß zwischen den Emitter des Steuertransistors (T2, T3) und die Basis des Treibertransistors (T4) ein Emittervorwiderstand (R3) geschaltet ist.

10. Leistungsendstufe nach Anspruch 8 oder 9, dadurch gekennzeichnet, daß der Steuertransistor (T2, T3) als Darlingtontransistor ausgebildet ist.

11. Leistungsendstufe nach einem der Ansprüche 1 bis 10, dadurch gekennzeichnet, daß die Darlingtontransistor-Kombination einen Zwischentransistor (T5) enthält, der zwischen dem Treibertransistor (T4) und dem Leistungstransistor (T6) in einer Darlingtonschaltung angeordnet ist.

## Claims

1. Monolithically integrated power output stage for switching an inductive load (ZS) by means of a Darlington transistor combination which includes a driver transistor (T4) and a power transistor (T6), the base of the driver transistor (T4) being connected to an input terminal (B) and, furthermore, the emitter-collector path of the power transistor (T6) being connected in series with the inductive load (ZS), characterized in that a current limiting transistor (T1) and a first voltage divider (R4, R5) are provided, in that the first voltage divider consists of a first (R4) and a second ohmic resistor (R5) having different temperature coefficients, is connected with its ends between a point having a fixed potential (E) and the emitter of the driver transistor (T4) and is connected with its tap to the base of the current limiting transistor (T1), and in that the current limiting transistor (T1) is connected with its collector to the base of the driver transistor (T4) and with its emitter to the point having a fixed potential (E).

2. Power output stage according to Claim 1, characterized in that between the point having a fixed potential (E) and the emitter-collector path of the power transistor (T6), an additional ohmic resistor (R8) used as current regulating resistor is connected, the temperature coefficient of which is different from the temperature coefficients of the first (R4) and the second ohmic resistor (R5).

3. Power output stage according to Claim 2, characterized in that the ohmic resistors (R4, R5, R8), the resistance values of which have different temperature coefficients, are of the ion implantation type.

4. Power output stage according to one of Claims 1 to 3, characterized in that the resistor (R5) of the first voltage divider (R4, R5), which is connected to the point having a fixed potential (E), can be trimmed in order to adapt the power output stage to its respective purpose of use.

5. Power output stage according to one of Claims 1 to 4, characterized in that an input series resistor (R1) is connected between the base of the driver transistor (T4) and the input terminal (B) of the power output stage.

6. Power output stage according to Claim 5, characterized in that the driver transistor (T4) is an npn transistor and that a diode (D1) is connected in parallel with the input series resistor (R1), the anode of the diode (D1) being connected to the base of the driver transistor (T4).

7. Power output stage according to Claim 5 or 6, characterized in that a first Zener diode (ZD1) is connected between the input terminal (B) and the base of the current limiting transistor (T1) and in that a resistor (R2) is connected in parallel with the first Zener diode (ZD1) so that the power output stage is essentially disconnected when the voltage at the input terminal (B) noticeably exceeds the Zener voltage of the first Zener diode (ZD1).

8. Monolithically integrated power output stage for switching an inductive load (ZS) which, in particular, is used as ignition coil, according to one of Claims 1 to 7, characterized in that the base-collector path of the power transistor (T6) is connected in parallel with a second voltage divider (R6), in that a tap of the second voltage divider (R6) is connected to the base of a control transistor (T2, T3), the collector of which is connected to the collector of the power transistor (T6) and the emitter of which is connected to the base of the driver transistor (T4), and in that a second Zener diode (ZD2) is connected between a tap of the second voltage divider (R6) and the emitter of the power transistor (T6).

9. Power output stage according to Claim 8, characterized in that an emitter bias resistor (R3) is connected between the emitter of the control transistor (T2, T3) and the base of the driver transistor (T4).

10. Power output stage according to Claim 8 or 9, characterized in that the control transistor (T2, T3) is constructed as Darlington transistor.

11. Power output stage according to one of Claims 1 to 10, characterized in that the Darlington transistor combination contains an intermediate transistor (T5) which is arranged between the driver transistor (T4) and the power transistor (T6) in a Darlington circuit.

## Revendications

1. Etage de sortie de puissance intégré monolithiquement, destiné à la commutation d'une charge inductive (ZS) à une combinaison de transistor à montage Darlington, incluant un transistor pilote (T4) et un transistor de puissance (T6), la base du transistor pilote (T4) étant reliée à une borne d'entrée (B) et la section émetteur-collecteur du transistor de puissance (T6) étant en outre branchée en série avec la charge inductive (ZS), caractérisé en ce qu'un transistor limiteur de courant (T1) et un diviseur de tension (R4, R5) sont prévus, en ce que le premier diviseur de tension se compose d'une première résistance (R4) et d'une deuxième résistance ohmique (R5) à coefficients de températures différents, ses extrémités étant raccordées entre un point à potentiel fixe (E) et l'émetteur du transistor pilote (T4), et sa prise étant placée sur la base du transistor limiteur de courant (T1), et en ce que le transistor limiteur de courant (T1) est raccordé par son collecteur à la base du transistor pilote (T4) et par son émetteur au point à potentiel fixe (E).

2. Etage de sortie de puissance selon la revendication 1, caractérisée en ce qu'une résistance ohmique supplémentaire (R8) servant de résistance de régulation de courant est branchée entre le point à potentiel fixe (E) et la section émetteur-collecteur du transistor de puissance (T6), résistance (R8) dont le coefficient de température est différent des coefficients de température de la première (R4) et de la deuxième résistance ohmique (R5).

3. Etage de sortie de puissance selon la revendication 2, caractérisée en ce que les résistances ohmiques (R4, R5, R8) dont les valeurs de résistance présentent des coefficients de température différents sont du type à implantation d'ions.

4. Etage de sortie de puissance selon l'une des revendications 1 à 3, caractérisée en ce que la résistance (R5) du premier diviseur de tension (R4, R5) qui est raccordé au point à potentiel fixe (E) est réglable, en vue d'ajuster l'étage de sortie de puissance à l'application respective.

5. Etage de sortie de puissance selon l'une des revendications 1 à 4, caractérisée en ce qu'une résistance série d'entrée (R1) est branchée entre la base du transistor pilote (T4) et la borne d'entrée (B) de l'étage de sortie de puissance.

6. Etage de sortie de puissance selon la revendication 5, caractérisée en ce que le transistor pilote (T4) est un transistor npn et en ce qu'une diode (D1) est branchée en parallèle de la résistance série d'entrée (R1), l'anode de la diode (D1) est branchée en parallèle de la résistance série d'entrée (R1), l'anode de la diode (D1) étant raccordée à la base du transistor pilote (T4).

7. Etage de sortie de puissance selon la revendication 5 ou 6, caractérisée en ce qu'une première diode Zener (ZD1) est branchée entre la borne d'entrée (B) et la base du transistor limiteur de courant (T1) et en ce qu'une résistance (R2) est branchée en parallèle de la première diode Zener (ZD1), de sorte que l'étage de sortie de puissance soit pratiquement mis hors service si la tension à la borne d'entrée (B) dépasse sensiblement la tension Zener de la première diode Zener (ZD1).

8. Etage de sortie de puissance intégré monolithiquement destiné à la commutation d'une charge inductive (25), servant en particulier à une bobine d'allumage, selon l'une des revendications 1 à 7, caractérisée en ce qu'un deuxième diviseur de tension (R6) est branché en parallèle du tronçon base-collecteur du transistor de puissance (T6), en ce que la base d'un transistor de commande (T2, T3), dont le collecteur est raccordé au collecteur du transistor de puissance (T6) et dont l'émetteur est relié à la base du transistor pilote (T4), est raccordée à une prise du deuxième diviseur de tension (R6), et en ce qu'une deuxième diode Zener (ZD2) est branchée entre une prise du deuxième diviseur de tension (R6) et l'émetteur du transistor de puissance (T6).

9. Etage de sortie de puissance selon la revendication 8, caractérisée en ce qu'une résistance série d'émetteur (R3) est branchée entre l'émetteur du transistor de commande (T2, T3) et la base du transistor pilote (T4).

10. Etage de sortie de puissance selon la revendication 8 ou 9, caractérisée en ce que le transistor de commande (T2, T3) est réalisé sous la forme d'un transistor Darlington.

11. Etage de sortie de puissance selon l'une des revendications 1 à 10, caractérisée en ce que la combinaison de transistors à montage Darlington contient un transistor intermédiaire (T5) disposé entre le transistor pilote (T4) et le transistor de puissance (T6) dans un montage Darlington.

FIG. 1

FIG. 2

FIG. 3

1

S ○    G ○    D ○

4

P    2    6    P    7

n⁻

n⁺

<u>FIG. 4</u>

A ○    B ○

4

R    n    p    8

n⁻

n⁺

<u>FIG. 5</u>

A ○    B ○

4    3

R    P    8

n⁻

n⁺

<u>FIG. 6</u>

FIG. 7

FIG. 8

EP 0 174 473 B1